**Europäisches Patentamt**

**European Patent Office**

**Office européen des brevets**

(11) Numéro de publication: **0 052 040**
**B1**

(12) **FASCICULE DE BREVET EUROPEEN**

(45) Date de publication du fascicule du brevet: **13.02.85**

(51) Int. Cl.⁴: **H 03 F 3/50**

(21) Numéro de dépôt: **81401682.0**

(22) Date de dépôt: **23.10.81**

(54) **Amplificateur intégré en classe AB en technologie CMOS.**

(30) Priorité: **23.10.80 FR 8022662**

(43) Date de publication de la demande:
**19.05.82 Bulletin 82/20**

(45) Mention de la délivrance du brevet:
**13.02.85 Bulletin 85/07**

(84) Etats contractants désignés:
**DE FR GB IT NL**

(56) Documents cités:
**IEEE JOURNAL OF SOLID-STATE CIRCUITS,
vol. SC-14, no. 6, décembre 1979, NEW YORK
(US) G. ERDI: "A 300 V/us Monolithic Voltage
Follower", pages 1059-1065**

**RCA REVIEW, vol. 37, no. 3, septembre 1976,
SOMERVILLE, NEW YORK (US) O.H. SCHADE
Jr.: "A New Generation of MOS/Bipolar
Operational Amplifiers", pages 404-424**

**IBM TECHNICAL DISCLOSURE BULLETIN, vol.
8, no. 10, mars 1966, NEW YORK (US) K.K.
OSWALD: "Class B emitter-follower", pages
1447-1448**

(73) Titulaire: **SOCIETE POUR L'ETUDE ET LA
FABRICATION DE CIRCUITS INTEGRES
SPECIAUX - E.F.C.I.S.
17, avenue des Martyrs
F-38100 Grenoble (FR)**

(72) Inventeur: **Bertails, Jean-Claude
THOMSON-CSF SCPI 173, bld Haussmann
F-75360 Paris Cedex 08 (FR)**
Inventeur: **Perrin, Christian
THOMSON-CSF SCPI 173, bld Haussmann
F-75360 Paris Cedex 08 (FR)**
Inventeur: **Tallaron, Louis
THOMSON-CSF SCPI 173, bld Haussmann
F-75360 Paris Cedex 08 (FR)**

(74) Mandataire: **Guérin, Michel et al
THOMSON-CSF SCPI 173, Bld Haussmann
F-75379 Paris Cédex 08 (FR)**

Courier Press, Leamington Spa, England.

## Description

La présente invention concerne les circuits intégrés à base de silicium, réalisés en technologie CMOS (Métal Oxyde Semiconducteur), c'est-à-dire comportant essentiellement des transistors à effet de champ à grille de commande isolée par un oxyde.

Cette technologie permet de réaliser notamment des amplificateurs linéaires mais, si l'on veut augmenter la puissance disponible en sortie, on est conduit à une limitation en ce qui concerne d'une part l'impédance de sortie (trop forte pour des transistors MOS si on veut alimenter par exemple une charge normalisée de 600 Ohms), et d'autre part les dimensions des transistors de sortie sur le circuit intégré: pour un même courant de sortie, un transistor MOS occupe plus d'espace qu'un transistor bipolaire.

On souhaite donc que l'étage de sortie de l'amplificateur comporte des transistors bipolaires, ce qu'il est d'ailleurs possible de faire en utilisant la technologie CMOS, le circuit intégré réalisé comprenant alors à la fois des transistors bipolaires et des transistors à effet de champ MOS.

On peut penser alors à utiliser classiquement comme étage de sortie un étage à deux transistors bipolaires NPN et PNP, montés en "push-pull" pour faire travailler l'amplificateur en classe B ou AB, c'est-à-dire avec d'une part une linéarité suffisamment bonne et d'autre part un courant de fonctionnement au repos nul (classe B) ou suffisamment faible pour ne pas conduire à des pertes trop importantes (classe AB).

Malheureusement, on ne peut faire coexister en pratique sur un même substrat que des transistors bipolaires NPN avec les transistors MOS du substrat. Il n'est pas possible d'obtenir simplement un transistor PNP et un transistor NPN à caractéristiques symétriques à monter en push-pull.

L'article de George Erdi dans IEE Journal of Solid State Circuits, Vol. SC-14, n° 6, décembre 1979, page 1059, propose une solution où l'étage de puissance comprend deux transistors NPN dont l'un reçoit le signal à amplifier et l'autre est commandé par un étage différentiel à transistors NPN et transistors à effet de champ à jonction (JFET), cet étage différentiel recevant comme entrées d'une part la sortie de l'étage de puissance et d'autre part une tension prélevée sur le collecteur d'un transistor NPN supplémentaire monté en suiveur de tension recevant le signal d'entrée à amplifier.

La présente invention propose une autre solution consistant à mettre en série un transistor bipolaire NPN et un transistor MOS pour constituer les deux transistors de puissance d'un étage final de type push-pull.

L'amplificateur intégré comprend un étage de sortie constitué par:

— un premier transistor bipolaire NPN (T1),

— un deuxième transistor bipolaire NPN (T2) recevant sur sa base, de même que le premier, le signal à amplifier, ce deuxième transistor étant essentiellement monté en suiveur de tension et étant en série avec une source de courant (SC) entre deux bornes d'alimentation;

— un troisième transistor (T3) en série avec le premier entre les deux bornes d'alimentation, leur point de jonction constituant la sortie de l'amplificateur;

— un amplificateur différentiel (AD) dont les entrées sont reliées respectivement aux émetteurs des deux transistors NPN (T1 et T2) et dont la sortie est reliée au troisième transistor (T3) pour commander la polarisation de ce dernier dans un sens tendant à asservir la tension d'émetteur du premier transistor bipolaire (T1) à celle du second (T2).

Selon l'invention, en vue de faire fonctionner l'amplificateur en classe B ou AB et de l'intégrer en technologie MOS, le troisième transistor est un transistor MOS à canal N relié par son drain à l'émetteur du premier transistor et par sa grille de commande à la sortie de l'amplificateur différentiel.

Le transistor MOS à canal N a une forte géométrie (pour obtenir un courant de sortie suffisant) et son rôle est analogue à celui du transistor PNP des étages push-pull classiques.

Ainsi, le signal à amplifier commande directement la conduction du premier transistor bipolaire, mais il commande indirectement la conduction du transistor NMOS par l'intermédiaire d'un second transistor bipolaire qui reproduit sur son émetteur suiveur la tension à amplifier et d'un amplificateur différentiel qui agit sur la conduction du transistor MOS dans un sens tendant à asservir la tension de sortie de l'étage amplificateur à la tension à amplifier.

On notera que la tension d'émetteur du second transistor bipolaire suit fidèlement (à une tension base/émetteur près) la tension à amplifier, car le second transistor bipolaire, contrairement au premier, est peu chargé et il fonctionne en classe A, donc de manière très linéaire.

Le circuit ainsi proposé a entre autres l'avantage de présenter une bonne linéarité, une consommation de courant au repos suffisamment faible et une bonne symétrie de fonctionnement en positif et en négatif.

La fidélité de reproduction de la tension à amplifier est d'autant plus grande si on prévoit qu'une source de courant (un transistor MOS) est placée en série avec l'émetteur du second transistor bipolaire.

Les deux transistors bipolaires NPN peuvent avoir des géométries dans un rapport notablement différent de un (le premier étant généralement le plus gros puisqu'il se situe à la sortie même de l'étage amplificateur de puissance, le second étant généralement de dimensions minimales).

On choisit d'ailleurs ce rapport de géométries, qui déterminera le courant de repos dans le premier transistor NPN en fonction de la résistance de charge, donc du courant que doit fournir le montage.

On verra dans la description détaillée quelle est l'influence des géométries sur le courant de repos.

Pour diminuer l'influence de la tension d'écart et de la tension de décalage de l'amplificateur différentiel, on place des résistances dans les émetteurs des transistors bipolaires, ces résistances jouant le rôle d'une contre-réaction d'émetteur réduisant la sensibilité des transistors aux variations de tension base. Ces résistances sont choisies avec des valeurs relatives dans le rapport inverse des géométries des transistors correspondants.

L'amplificateur différentiel peut être un amplificateur classique à transistors MOS à miroirs de courant possédant une source de courant alimentant en parallèle deux groupes de deux transistors MOS en série.

D'autres caractéristiques et avantages de l'invention apparaitront à la lecture de la description détaillée qui suit et qui est faite en référence aux dessins annexés dans lesquels:

— la figure 1 représente un schema général de l'amplificateur selon l'invention;

— la figure 2 en représente un schéma plus détaillé.

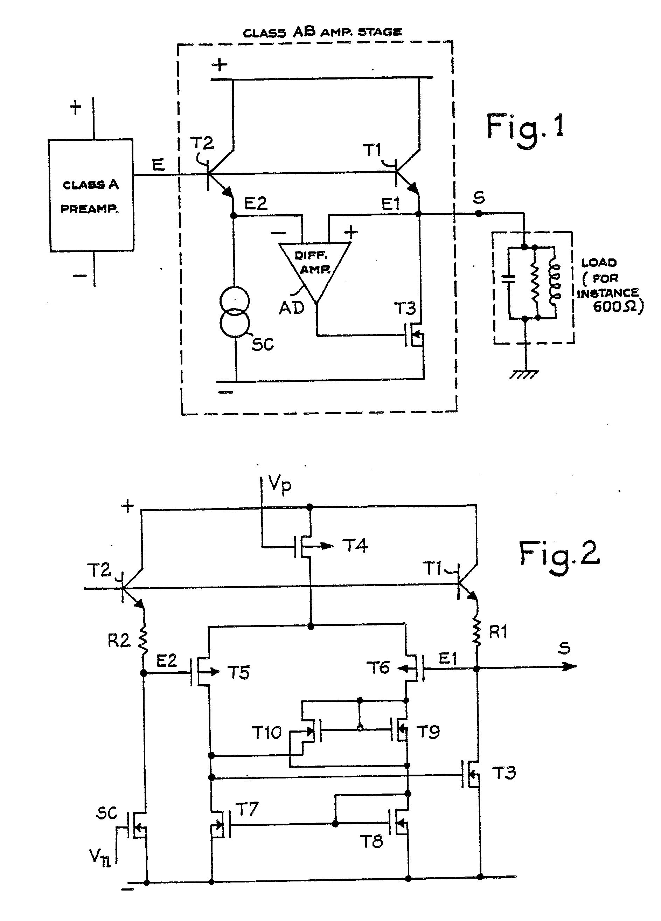

L'amplificateur selon l'invention, destiné à fonctionner en classe AB comprend plusieurs étages de preamplification et un étage de sortie qui est l'étage fonctionnant à proprement parler en classe AB. Seul cet étage de sortie intéresse la présente invention et on a simplement représenté à la figure 1 schématiquement un preamplificateur d'entrée, fonctionnant en principe en classe A et couplé à l'entrée de l'étage de sortie, la sortie de l'étage en question étant reliée à la charge. Une application importante consiste à charger l'amplificateur par une charge de 600 Ohms.

Les étages préamplificateurs et l'étage de sortie sont intégrés sur un même substrat de silicium et sont réalisés selon la technologie CMOS, cette technologie incluant comme on l'a dit la possibilité de réaliser des transistors bipolaires NPN sur le même substrat que les transistors MOS.

L'étage amplificateur de sortie comprend un premier transistor bipolaire $T_1$, NPN, dont la base est directement couplée à l'entrée E de l'étage de sortie et reçoit donc le signal à amplifier en provenance des étages de préamplifications.

Un autre transistor bipolaire NPN $T_2$ reçoit également sur sa base le même signal à amplifier et a pour rôle d'établir sur son émetteur $E_2$ un signal reproduisant le signal d'entrée à amplifier.

Le premier transistor bipolaire $T_1$ est placé en série, à la manière d'un étage push-pull, avec un transistor $T_3$ qui est un transistor MOS à canal N. Les transistors NPN $T_1$ et MOS $T_3$ sont en série entre les bornes d'alimentation positive et négative d'une alimentation symétrique, et la sortie S de l'étage amplificateur selon l'invention est prise au point de jonction entre l'émetteur $E_1$ du transistor $T_1$ et le drain du transistor MOS $T_3$; cette sortie S est prise par rapport à la masse commune aux alimentations symétriques comme on le fait dans les étages push-pull bipolaires.

On cherche à faire fonctionner l'étage amplificateur en classe AB, c'est-à-dire ni tout-à-fait en classe A où le signal de sortie serait plus linéaire mais imposerait un courant de repos dans les transistors $T_1$ et $T_3$ élevé et donc une trop grande consommation à vide, ni en classe B pure où le courant de repos est pratiquement nul mais où on a des problèmes de linéarité à cause de la distorsion de raccordement entre les alternances positives et négatives sur la borne de sortie S, le transistor $T_1$ prenant en charge complètement les alternances positives et le transistor $T_3$ prenant en charge complètement les alternances négatives.

Ici, on fonctionne en classe AB, c'est-à-dire avec un courant de repos permanent parcourant les transistors $T_1$ et $T_3$ même en l'absence de signal à l'entrée E de l'amplificateur. Pendant les alternances positives du signal, le transistor $T_1$ conduit essentiellement le courant dans la charge, mais le transistor $T_3$ dérivé une partie de ce courant; pendant les alternances négatives, le transistor $T_3$ absorbe la majorité du courant dans la charge mais le transistor $T_1$ continue à conduire un peu.

Pendant les alternances positives du signal à amplifier appliqué à l'entrée E, la tension de sortie en S, c'est-à-dire sur l'émetteur $E_1$ du transistor $T_1$ suit pratiquement la tension du signal à amplifier car le transistor $T_1$ reçoit sur sa base ce signal, et son émetteur le suit à la tension base/émetteur près.

Pendant les alternances négatives, il faut que le courant soit dérivé par l'étage de sortie depuis la charge et ce n'est pas le transistor $T_1$ qui peut faire cette dérivation de courant puisqu'il est connecté à la borne positive de l'alimentation symétrique. C'est au contraire le transistor $T_3$ qui doit recueillir le courant provenant de la charge et le faire passer vers la borne négative de l'alimentation.

Le transistor MOS $T_3$ est à cet effet commandé, selon l'invention, par la sortie d'un amplificateur différentiel AD dont les entrées non inverseuse et inverseuse sont connectées respectivement à l'émetteur $E_1$ du transistor $T_1$ et à l'émetteur $E_2$ du transistor $T_2$. C'est la grille de commande du transistor $T_3$ qui est couplée à la sortie de l'amplificateur différentiel AD et la conduction du transistor $T_3$ dépend donc de l'écart entre les tensions d'émetteur des transistors $T_1$ et $T_2$. Comme l'augmentation de la tension grille du transistor $T_3$ augmente sa conduction, et abaisse en conséquence le potentiel de la sortie S, on voit qu'on réalisé un asservissement de cette sortie S sur la tension d'émetteur $E_2$ du transistor $T_2$. En effet, si cette tension diminue, la conduction de $T_3$ augmentera et fera diminuer la tension de sortie en S; si la tension en $E_2$ augmente, la conduction du transistor $T_3$ diminuera et la tension S augmentera donc.

Le transistor bipolaire NPN $T_2$ est monté en émetteur suiveur, c'est-à-dire que d'une par son collecteur est connecté à la borne d'alimentation positive, la sortie est prise sur l'émetteur $E_2$ et la charge de l'émetteur est constituée par une source de courant SC en série entre l'émetteur et l'alimentation négative. Par conséquent, étant donné le courant constant traversant le transistor $T_2$, la tension base/émetteur de ce transistor est constante et le signal d'entrée à amplifier en E se retrouve reproduit en $E_2$ à la tension base/émetteur constante près.

L'amplificateur différentiel AD détecte l'écart entre la tension de sortie en S et cette tension en $E_2$ et commande le transistor $T_3$ de manière à faire suivre par la sortie la tension d'entrée.

Pendant les alternances positives du signal à amplifier, le transistor NPN $T_1$, commandé par sa base, conduit dans la charge autant de courant qu'il est nécessaire pour que le potentiel de sortie en S suive la tension d'entrée en E. Pendant ce temps, l'amplificateur différentiel AD a naturellement tendance à réduire le courant traversant le transistor $T_3$ car le potentiel de $E_2$ se retrouve supérieur au potentiel de $E_1$ (du fait que le VBE du transistor $T_1$ conducteur est normalement plus grand que le VBE du transistor $T_2$ qui conduit de manière constante). Cet effet est d'autant plus prononcé que la croissance du signal positif est plus rapide: si la sortie a du mal à suivre l'entrée à cause de la vitesse de variation de tension à l'entrée, le transistor $T_3$ se bloquera d'autant plus rapidement et facilitera la transmission intégrale vers la charge de tout le courant traversant le transistor $T_1$.

Pendant les alternances négatives, seul le transistor $T_3$ peut récupérer le courant négatif circulant dans la charge; l'amplificateur différentiel se charge de faire conduire $T_3$ de manière que la tension de sortie reste égale à la tension sur l'émetteur $E_2$ (à la tension d'écart de l'amplificateur différentiel près). Dans ce temps, le courant traversant le transistor $T_1$ reste faible puisque sa tension base-émetteur est égale à la tension base-émetteur du transistor $T_2$ diminuée de la tension d'écart de l'amplificateur différentiel. Par ailleurs, on voit que si la tension d'entrée varie rapidement vers les valeurs négatives, l'amplificateur différentiel agira fortement sur la conduction du transistor $T_3$ pour que la tension de sortie suive la tension d'entrée.

On peut remarquer que si on néglige la tension d'écart aux bornes de l'amplificateur différentiel, les tensions base-émetteur des transistors $T_1$ et $T_2$ sont identiques, et si le courant émetteur du transistor $T_1$ est imposé, le courant permanent traversant le transistor $T_1$ pour une valeur nulle ou négative du signal d'entrée, sera proportionnel au courant dans le transistor $T_2$, dans un rapport qui correspond au rapport des géométries des transistors $T_1$ et $T_2$: si le transistor $T_1$ est dix fois plus gros que le transistor $T_2$, ce qui est normal puisque le transistor $T_1$ constitue l'étage de sortie, le courant de repos sera dix fois le courant de la source de courant SC. Ceci doit être modulé évidemment en fonction de l'amplitude de la tension d'écart aux bornes de l'amplificateur différentiel.

On a représenté à la figure 2 un exemple détaillé de circuit mettant en oeuvre l'invention, circuit dans lequel seuls $T_1$ et $T_2$ sont des transistors bipolaires, tous les autres éléments étant constitués par des transistors MOS.

On retrouve sur le schéma de la figure 2 les transistors bipolaires $T_1$ et $T_2$ NPN et le transistor $T_3$ MOS à forte géométrie (par rapport aux autres transistors MOS de l'amplificateur), cette forte géométrie étant nécessaire car c'est le transistor $T_3$ qui, avec le transistor $T_1$, absorbe le courant principal de l'amplificateur).

La source de courant SC en série avec l'émetteur du transistor $T_2$ est constituée simplement par un transistor MOS dont la grille de commande est alimentée à tension constante.

L'amplificateur différentiel comprend essentiellement d'abord un montage classique avec une source d'alimentation en courant constituée par un transistor MOS $T_4$ alimentant en parallèle deux groupes de transistors MOS en série, respectivement $T_5$, PMOS et $T_7$ NMOS d'une part, et $T_6$, PMOS et $T_8$ NMOS d'autre part; les électrodes de commande des transistors $T_5$ et $T_6$ sont reliées respectivement aux bornes $E_1$ et $E_2$ (essentiellement les émetteurs des transistors bipolaires $T_1$ et $T_2$), ces entrées $E_1$ et $E_2$ constituant les entrées de l'amplificateur différentiel; la sortie est prise sur le drain du transistor $T_7$ et commande l'électrode de grille du transistor MOS $T_3$ à forte géométrie conformément au schéma de la figure 1.

Le schéma qui vient d'être décrit est un schéma classique d'amplificateur différentiel à 5 transistors MOS à miroir de courants; si on connecte le drain du transistor $T_8$ avec sa grille de commande, on obtient une sortie non différentielle en tension, positive ou négative par rapport à la masse commune des alimentations symétriques. Ce schéma classique d'amplificateur différentiel à 5 MOS est légèrement modifié dans le cas présent au moyen de deux transistors $T_9$ et $T_{10}$ qui établissent une dérivation de courant en vue de créer une polarisation du transistor $T_3$ même lorsque c'est le transistor $T_1$ bipolaire qui doit conduire (c'est-à-dire lors des alternances positives du signal à amplifier).

Le transistor $T_9$ est inséré en série entre les transistors $T_6$ et $T_8$, il a son drain connecté à sa grille; le transistor $T_{10}$ est connecté de manière croisée entre les deux branches en parallèle alimentées par la source de courant $T_4$; plus précisément il est relié entre le point de jonction de $T_6$ et $T_9$ et le point de jonction de $T_5$ et $T_7$; son drain est connecté à sa grille de commande.

Cette disposition permet que lorsque l'amplificateur différentiel est déséquilibré dans un sens, pour les alternances négatives du signal à amplifier, l'amplificateur différentiel joue son rôle normalement, le transistor $T_{10}$ étant bloqué; au contraire, lors des alternances positives de la tension à amplifier, l'amplificateur différentiel fournit malgré tout une tension de polarisation au transistor $T_3$ pour le faire conduire partiellement bien que ce soit le transistor $T_1$ qui fournit alors l'essentiel du courant à la charge. Ce résultat est obtenu du fait que la transistor $T_{10}$ est rendu conducteur lors des alternances positives, le courant dans le transistor $T_6$ se partageant alors entre

les transistors $T_9$ et $T_{10}$ selon leur géométrie.

On aboutit alors à un fonctionnement plus linéaire car il tend plus vers la classe A que vers la classe B et on réduit les problèmes de distorsions de raccordements.

Comme on peut le remarquer sur la figure 2, on a inclu une légère modification par rapport au schéma de base de la figure 1; il s'agit de la présence de résistances d'émetteurs pour les transistors bipolaires $T_1$ et $T_2$: une résistance $R_1$ a été mise en série dans l'émetteur du transistor $T_1$ et une résistance $R_2$ dans l'émetteur du transistor $T_2$, les points d'entrée $E_1$ et $E_2$ de l'amplificateur différentiel étant alors pris non pas directement sur l'émetteur des transistors bipolaires mais après les résistances qui sont ainsi considérées comme faisant partie intégrale de l'émetteur. Ces résistances ont pour fonction de diminuer l'influence de la tension d'écart aux bornes de l'amplificateur différentiel en constituant une contre réaction d'émetteur rendant les transistors $T_1$ et $T_2$ moins sensibles aux variations de tensions en $E_1$ et $E_2$.

Les résistances $R_1$ et $R_2$ sont choisies dans le rapport inverse des géométries des transistors correspondants $T_1$ et $T_2$ afin qu'elles aient la même influence relative sur ces transistors.

## Revendications

1. Amplificateur intégré comprenant un étage de sortie constitué par:
— un premier transistor bipolaire NPN (T1),
— un deuxième transistor bipolaire NPN (T2) recevant sur sa base, de même que le premier, le signal à amplifier, ce deuxième transistor étant essentiellement monté en suiveur de tension et étant en série avec une source de courant (SC) entre deux bornes d'alimentation;
— un troisième transistor (T3) en série avec le premier entre les deux bornes d'alimentation, leur point de jonction constituant la sortie de l'amplificateur;
— un amplificateur différentiel (AD) dont les entrées sont reliées respectivement aux émetteurs des deux transistors NPN (T1 et T2) et dont la sortie est reliée au troisième transistor (T3) pour commander la polarisation de ce dernier dans un sens tendant à asservir la tension d'émetteur du premier transistor bipolaire (T1) à celle du second (T2);
caractérisé en ce que, en vue de faire fonctionner l'amplificateur en classe B ou AB et de l'intégrer en technologie MOS, le troisième transistor (T3) est un transistor MOS à canal N relié par son drain à l'émetteur du premier transistor et par sa grille de commande à la sortie de l'amplificateur différentiel.

2. Amplificateur selon la revendication 1, caractérisé par le fait qu'une résistance (R1, R2) est insérée en série avec l'émetteur de chacun des transistors bipolaires, les valeurs relatives de ces résistances étant dans le rapport inverse des géométries des transistors correspondants.

3. Amplificateur selon l'une des revendications 1 et 2, caractérisé par le fait que l'amplificateur différentiel est un amplificateur à transistors MOS à miroir de courants (une source de courant alimentant en parallèle deux groupes de deux transistors MOS en série).

4. Amplificateur selon la revendication 4, caractérisé par le fait que l'amplificateur différentiel possède une contre-réaction (T9, T10) destinée à conserver une certaine conductivité au transistor MOS à canal N en série avec le premier transistor NPN même lors des alternances positives de la tension de sortie.

## Patentansprüche

1. Integrierter Verstärker mit einer Ausgangsstufe, die
— einen ersten bipolaren Transistor NPN (T1),
— einen zweiten bipolaren Transistor NPN (T2), der ebenso wie der erste Transistor au seiner Basis das zu verstärkende Signal zugeführt erhält und im wesentlichen als Spannungsfolger geschaltet ist und in Reihe mit einer Stromquelle (SC) zwischen zwei Stromversorgungsklemmen liegt,
— einen dritten Transistor (T3) in Reihe mit dem ersten zwischen den beiden Stromversorgungsklemmen, deren gemeinsamer Punkt den Verstärkerausgang bildet,
— und einen Differentialverstärker (AD) aufweist, dessen Eingänge je an den Emitter eines der beiden NPN-Transistoren (T1 und T2) und dessen Ausgang an den dritten Transistor (T3) angeschlossen ist, um die Vorspannung dieses letzteren in einer solchen Richtung zu steuern, daß die Emitterspannung des ersten bipolaren Transistors (T1) der des zweiten (T2) angepaßt wird,
dadurch gekennzeichnet, daß der dritte Transistor (T3) ein N-Kanal-MOS-Transistor ist, der mit seinem Drainanschluß an den Emitter des ersten Transistors und mit seinem Steuergitteranschluß an den Ausgang des Differentialverstärkers angeschlossen ist, damit der Verstärker in Klasse B oder AB betrieben und in MOS-Technik integriert wird.

2. Verstärker nach Anspruch 1, dadurch gekennzeichnet, daß ein Widerstand (R1, R2) in Reihe mit dem Emitter jedes der bipolaren Transistoren eingefügt ist, wobei die relativen Werte dieser Widerstände sich im umgekehrten Verhältnis der Geometrien der entsprechenden Transistoren verhalten.

3. Verstärker nach einem der Ansprüche 1 und 2, dadurch gekennzeichnet, daß der Differentialverstärker MOS-Transistoren vom Stromspiegeltyp enthält (eine Stromquelle speist parallel zwei Gruppen von zwei in Reihe geschalteten MOS-Transistoren).

4. Verstärker nach Anspruch 4, dadurch gekennzeichnet, daß der Differentialverstärker eine Gegenkopplung (T9, T10) besitzt, die dem N-Kanal-MOS-Transistor in Reihe mit dem ersten NPN-Transistor eine gewisse Konduktivität selbst während der positiven Halbwellen der Ausgangsspannung erhalten soll.

## Claims

1. An integrated amplifier having an output stage which is constituted by
— a first bipolar NPN transistor (T1),
— a second bipolar NPN transistor (T2), the base of which receives, as well as the base of the first transistor, the signal to be amplified, this second transistor being substantially mounted in a voltage follower configuration and being branched in series with a current source (SC) between two power supply terminals,
— a third transistor (T3) branched in series with the first transistor between the two power supply terminals, the connection point between these two transistors constituting the amplifier output,
— and a differential amplifier (AD), the inputs of which are connected to the emitters of the two NPN transistors (T1 and T2) respectively and the output of which is connected to the third transistor (T3) in order to control the biasing of the latter in such a way that the emitter voltage of the first bipolar transistor (T1) is tuned to that of the second (T2),
characterized in that in view of making the amplifier function in class B or class AB and of integrating it in MOS technology, the third transistor (T3) is an N channel MOS transistor the drain of which is connected to the emitter of the first transistor and the control grid of which is connected to the output of the differential amplifier.

2. An amplifier according to claim 1, characterized in that a resistor (R1, R2) is inserted in series with the emitter of each one of the bipolar transistors, the relative resistance values of these resistors being inversely related to the geometry ratio of the corresponding transistors.

3. An amplifier according to one of the claims 1 and 2, characterized in that the differential amplifier is an amplifier having MOS transistors with current mirrors (a current source feeding in parallel two groups of series connected MOS transistors).

4. An amplifier according to claim 4, characterized in that the differential amplifier is provided with a feed-back loop (T9, T10) conceived to conserve a certain conductivity in the N channel MOS transistor which is branched in series with the first NPN transistor even during the positive half-periods if the output voltage.

0 0 5 2 0 4 0

Fig.1

Fig.2

1